# EUROPÄISCHE PATENTANMELDUNG

(11) **EP 2 621 252 A2**
(43) Veröffentlichungstag der Anmeldung: **31.07.2013**
(21) Anmeldenummer: 13151968.8
(22) Anmeldetag: 18.01.2013
(51) Int. Cl.: H05K 1/11

(54) **Flexibler elektrischer Verbinder**

(30) Priorität: 26.01.2012 DE 102012100663
(71) Anmelder: SUMIDA flexible connections GmbH, 01454 Radeberg (DE)
(72) Erfinder: Röder, Jürgen, 34393 Grebenstein (DE); Kirsten, Jan, 01917 Kamenz (DE)
(74) Vertreter: Carlsohn, Alexander

(57) **Zusammenfassung**

Die Erfindung betrifft einen elektrischen Verbinder mit einer Trägerfolie (2), auf der zumindest eine nicht verzweigte elektrische Leiterbahn (3) angeordnet ist. Dabei ist vorgesehen, dass die Leiterbahn (3) zwischen ihren Endabschnitten (4, 6) zumindest einen U- oder V-förmigen Abschnitt (5) aufweist, wobei zwischen den sich gegenüberliegenden Schenkeln (7, 8) des Abschnittes (5) ein erster Einschnitt (11) in die Trägerfolie (2) eingebracht ist.

## Beschreibung

Die Erfindung betrifft einen flexiblen elektrischen Verbinder, ein Verfahren zu dessen Herstellung sowie eine Verwendung des flexiblen elektrischen Verbinders.

Aus DE 101 45 828 A1 ist eine Folienleiterplatte bekannt, die als elektrischer Verbinder insbesondere in Kraftfahrzeugen eingesetzt werden soll. Die Folienleiterplatte weist eine Trägerfolie aus Kunststoff auf, auf der Leiterbahnen aus Kupferdünnschichten angeordnet sind. Die Leiterbahnen können mit einer Deckschicht abgedeckt sein, die ebenfalls aus Kunststoff besteht oder eine Lackschicht ist.

DE 101 45 828 A1 schlägt eine Ausgestaltung einer Folienleiterplatte vor, die eine möglichst große Variationsbereite an Anschlussmöglichkeiten bieten soll. Auf diese Weise sollen die Entwicklungs- und Fertigungskosten für die unterschiedlichen Leiterplatten eingespart werden. Zur Lösung dieser Aufgabe weist die dort vorgeschlagene Folienleiterplatte verzweigte Leiterbahnen auf, wobei die Verzweigungen, die sich bis zu einem der Endabschnitte erstrecken, auf Abzweigabschnitten der Trägerfolie angeordnet sind. Die Abzweigabschnitte sind Sollbruchlinien umgeben, die nach deren Durchtrennung ein Ausklappen der Abzweigabschnitte ermöglichen sollen. Der Abstand zwischen den beiden Endabschnitten einer Leiterbahn kann jedoch nicht verändert werden. Überdies sind Verzweigungen der Leiterbahnen auf der Trägerfolie in vielen Anwendungsfällen nicht erforderlich.

Aufgabe der Erfindung ist es, die Nachteile nach dem Stand der Technik zu beseitigen. Es soll insbesondere ein elektrischer Verbinder angegeben werden, der eine Anpassung der Endabschnitte der Leiterbahnen zulässt, so dass ein elektrischer Verbinder elektrische oder elektronische Bauelemente verbinden kann, die in unterschiedlichen Abständen zueinander angeordnet sind.

Diese Aufgabe wird durch die Merkmale der Ansprüche 1, 14 und 15 gelöst. Zweckmäßige Ausgestaltungen der Erfindungen ergeben sich aus den Merkmalen der Unteransprüche.

Nach Maßgabe der Erfindung ist ein elektrischer Verbinder mit einer Trägerfolie, auf der zumindest eine nicht verzweigte elektrische Leiterbahn angeordnet ist, vorgesehen, wobei die Leiterbahn zwischen ihren Endabschnitten zumindest einen U- oder V-förmigen Abschnitt aufweist, wobei zwischen den sich gegenüberliegenden Schenkeln des Abschnittes ein erster Einschnitt in die Trägerfolie eingebracht ist.

Der Ausdruck "elektrischer Verbinder mit einer Trägerfolie" soll in der vorliegenden Erfindung so verstanden werden, dass der elektrische Verbinder eine Trägerfolie aufweist.

Vorzugsweise beginnt der erste Einschnitt an einer Außenkante der Trägerfolie. In diesem Fall erstreckt sich der erste Einschnitt von der Außenkante zwischen den Schenkeln des U- oder V-förmigen Abschnittes in Richtung der Basis bzw. des Scheitelpunktes des Abschnittes, ohne jedoch die Basis oder den Scheitelpunkt zu erreichen. Vorteilhafterweise verläuft der erste Einschnitt auf der entlang der Symmetrieachse des U- oder V-förmigen Abschnittes. Ebenso bevorzugt kann der erste Einschnitt jedoch an einem anderen, dritten Einschnitt beginnen. Der erste Einschnitt erstreckt sich dann von dem dritten Einschnitt zwischen den Schenkeln des U- oder V-förmigen Abschnittes in Richtung der Basis bzw. Scheitelpunktes des Abschnittes, ohne jedoch die Basis oder den Scheitelpunkt zu erreichen. Der dritte Einschnitt wird nachstehend im Zusammenhang mit der zweiten Ausführungsform der Erfindung beschrieben.

Vorteilhafterweise verläuft der erste Einschnitt entlang der Symmetrieachse des U- oder V-förmigen Abschnittes. Die Länge der ersten Einschnitte sollte wenigstens 50 %, bevorzugt wenigstens 60 %, stärker bevorzugt wenigstens 70 % der Ausdehnung der Trägerfolie, gemessen in der Richtung des ersten Einschnitts von der Außenkante, an der der erste Einschnitt beginnt, bis zur folgenden Außenkante oder bis zum dritten Einschnitt betragen. Sind mehrere erste Einschnitte vorgesehen, so kann deren Länge gleich oder unterschiedlich sein.

Der erste Einschnitt ermöglicht es, den elektrischen Verbinder auseinanderzuziehen, wodurch der Abstand zwischen den Endabschnitten der Leiterbahnen verändert werden kann. Zusätzliche zu dem oder den ersten Einschnitten kann zumindest ein zweiter Einschnitt vorgesehen sein, der zwischen benachbarten Leiterbahnen ausgebildet ist. Die zweiten Einschnitte sind von allen Außenkante der Trägerfolie beabstandet. Die zweiten Einschnitte erleichtern das Auseinanderziehen des elektrischen Verbinders, indem sie eine Verschiebung der Leiterbahnen, bezogen auf die jeweils benachbarten Leiterbahnen ermöglichen. Vorzugsweise verlaufen die zweiten Einschnitte parallel zu dem oder den ersten Einschnitten. Die Länge der zweiten Einschnitte kann wenigstens 50 %, bevorzugt wenigstens 60 %, stärker bevorzugt wenigstens 70 % der Ausdehnung eines benachbarten Schenkels eines U- und V-förmigen Abschnitts betragen. Sind mehrere zweite Einschnitte vorgesehen, so kann deren Länge gleich oder unterschiedlich sein.

Vierte Einschnitte können sich zwischen den Endabschnitten benachbarter Leiterbahnen erstrecken, vorzugsweise parallel zu diesen. Die vierten Einschnitte erstrecken sich vorzugsweise von einer Außenkante, an die Endabschnitte der Leiterbahnen angrenzen, in Richtung des nächstliegenden Schenkels eines U- oder V-förmigen Abschnittes, ohne diesen jedoch zu erreichen. Die vierten Einschnitte können sich bis zu den zweiten Einschnitten erstrecken und in diese übergehen, vorzugsweise an einem Ende des zweiten Einschnittes. Vorzugsweise verlaufen die vierten Einschnitte quer zu den ersten Einschnitten. Ebenso bevorzugt verlaufen die vierten Einschnitte quer zu den zweiten Einschnitten. Ist zwischen benachbarten Leiterbahnen bereits ein dritter Einschnitt vorgesehen, so sollte zwischen diesen Leiterbahnen kein vierter Einschnitt vorgesehen sein. Die Länge der vierten Einschnitte entspricht vorzugsweise annähernd der mittleren Länge der beiden Endabschnitte, zwischen denen er verläuft. In einer Ausführungsform der Erfindung sind die Endabschnitte der Leiterbahnen an gegenüberliegenden Außenkanten der Trägerfolie angeordnet, wobei der zumindest eine erste Einschnitt an einer anderen Außenkante der Trägerfolie beginnt.

Die Leiterbahn kann mehrere U- oder V-förmige Abschnitte aufweisen, wobei die U-oder V-förmigen Abschnitte der Leiterbahn alternierend zu einer Außenkante oder zu der dazu gegenüberliegenden Außenkante der Trägerfolie geöffnet sind. Dabei kann ein Schenkel eines ersten U- oder V-förmigen Abschnittes gleichzeitig den Schenkel eines zweiten, benachbarten U- oder V-förmigen Abschnittes bilden. Erste Einschnitte sind dabei zweckmäßigerweise nur zwischen den Schenkeln der U- oder V-förmigen Abschnitte der äußeren Leiter eingebracht.

Auf der Trägerfolie können mehrere Leiterbahnen aufgebracht sein. Die Leiterbahnen sind durch die Trägerfolie elektrisch voneinander getrennt, aber mechanisch miteinander verbunden. Die Abstände zwischen benachbarten Leiterbahnen können beliebig gewählt werden; vorzugsweise sind sie äquidistant.

In einer ersten Ausführungsform weisen alle Leiterbahnen zumindest einen U- oder V-förmigen Abschnitt auf, der im Folgenden auch als "erster U- oder V-förmiger Abschnitt" bezeichnet wird. Der erste Einschnitt befindet sich dabei zwischen den Schenkeln der Leiterbahn, die benachbart zu der Außenkante verläuft, und erstreckt sich von der Außenkante in Richtung der Basis bzw. des Scheitelpunktes der beiden Schenkel. Dazu ist der U- oder V-förmige Abschnitt zu dieser Außenkante hin geöffnet. Der U- oder V-förmige Abschnitt der zu dieser äußeren Leiterbahn benachbarten, zweiten Leiterbahn umgibt vorzugsweise den U- oder V-förmigen Abschnitt der ersten Leiterbahn, wobei die Symmetrieachse des U- oder V-förmigen Abschnitts der zweiten Leiterbahn zweckmäßigerweise auf der Symmetrieachse des U- oder V-förmigen Abschnittes der äußeren Leiterbahn liegt. Der Abstand zwischen der äußeren Leiterbahn und der zu ihr benachbarten, zweiten Leiterbahn ist zweckmäßigerweise konstant. Zwischen der äußeren Leiterbahn und der zweiten Leiterbahn sind vorteilhafterweise zweite Einschnitte vorgesehen, wobei es besonderes bevorzugt ist, wenn sich die zweiten Einschnitte zwischen den benachbarten Schenkeln des U- oder V-förmigen Abschnittes der äußeren Leiterbahn und der zweiten Leiterbahn befinden. Vorzugsweise verlaufen die zweiten Einschnitte mittig zwischen den Schenkeln. Ist keine dritte Leiterbahn vorgesehen, so ist die zweite Leiterbahn ebenfalls eine äußere Leiterbahn, die benachbart zu einer Außenkante der Trägerfolie ist. Ist eine dritte, der zweiten Leiterbahn benachbarte Leiterbahn vorgesehen, so umgibt der U- oder V-förmige Abschnitt der dritten Leiterbahn vorzugsweise den U- oder V-förmigen Abschnitt der zweiten Leiterbahn, wobei die Symmetrieachse des U- oder V-förmigen Abschnitts der dritten Leiterbahn zweckmäßigerweise auf der Symmetrieachse des U-oder V-förmigen Abschnittes der zweiten Leiterbahn liegt. Der Abstand zwischen der dritten Leiterbahn und der zu ihr benachbarten, zweiten Leiterbahn ist zweckmäßigerweise konstant. Zwischen der zweiten Leiterbahn und der dritten Leiterbahn sind vorteilhafterweise zweite Einschnitte vorgesehen, wobei es besonderes bevorzugt ist, wenn sich die zweiten Einschnitte zwischen den benachbarten Schenkeln des U- oder V-förmigen Abschnittes der zweiten Leiterbahn und der dritten Leiterbahn befinden. Das für die dritte Leiterbahn gesagte gilt jeweils auch für jede weitere Leiterbahn mit dem Unterschied, dass an die Stelle der zweiten Leiterbahn die der weiteren Leiterbahn nächstliegende benachbarte Leiterbahn tritt.

Sind weitere U- oder V-förmige Abschnitte vorgesehen, so gilt das für den ersten U-oder V-förmigen Abschnitt gesagte auch für diese Abschnitte, wobei jedoch auf einen Abschnitt mit einem ersten Einschnitt, der sich von einer Außenkante der Trägerfolie erstreckt, ein U- oder V-förmiger Abschnitt folgt, der von einer dieser Außenkante gegenüberliegenden Außenkante ausgeht. Von dieser gegenüberliegenden Außenkante erstreckt sich der erste Einschnitt dann zwischen den Schenkeln des U-förmigen Abschnittes der Leiterbahn, die ihr benachbart ist.

In einer zweiten Ausführungsform der Erfindung sind zumindest eine erste nicht verzweigte Leiterbahn und zumindest eine zweite nicht verzweigte Leiterbahn vorgesehen, wobei sowohl die erste als auch die zweite Leiterbahn zwischen ihren jeweiligen U- oder V-förmigen Abschnitten jeweils einen ersten Einschnitt aufweisen und wobei die zweiten Leiterbahnen spiegelsymmetrisch zu den ersten Leiterbahnen auf der Trägerfolie angeordnet sind. Vorteilhafterweise ist zwischen den ersten Leiterbahnen und den zweiten Leiterbahnen ein dritter Einschnitt ausgebildet, der von den Außenkanten der Trägerfolie beabstandet ist. Es ist bevorzugt, dass der dritte Einschnitt im Wesentlichen quer zu den ersten Einschnitten verläuft. Es ist ebenso bevorzugt, dass der dritte Einschnitt im Wesentlichen quer zu den zweiten Einschnitten verläuft. Vorteilhafterweise verläuft der dritte Einschnitt durch das geometrische Zentrum der Trägerfolie. Der dritte Einschnitt kann parallel zu den Außenkanten der Trägerfolie ausgebildet sein, in die erste Einschnitte eingebracht sind.

Sind in der zweiten Ausführungsform der Erfindung mehrere erste Leiterbahnen vorgesehen, so entspricht die Anordnung der ersten Leiterbahnen der für die erste Ausführungsform beschriebenen Anordnung der Leiterbahnen, wobei jedoch alternierend erste Einschnitte von der Außenkante der Trägerfolie und von dem dritten Einschnitt ausgehen.

Sind in der zweiten Ausführungsform der Erfindung mehrere zweite Leiterbahnen vorgesehen, so entspricht die Anordnung der zweiten Leiterbahnen der für die erste Ausführungsform beschriebenen Anordnung der Leiterbahnen, wobei jedoch alternierend erste Einschnitte von der Außenkante der Trägerfolie und von dem dritten Einschnitt ausgehen.

Vorzugsweise sind in der zweiten Ausführungsform die zweiten Leiterbahnen spiegelsymmetrisch zu den ersten Leiterbahnen ausgebildet, wobei die Symmetrieachse vorteilhafterweise entlang des dritten Einschnittes verläuft.

In der zweiten Ausführungsform sollten die ersten Einschnitte, die von dem dritten Einschnitt ausgehen und sich zwischen den Schenkeln der U- oder V-förmigen Abschnitte der dem dritten Einschnitt benachbarten zweiten Leiterbahn erstrecken, von demselben Punkt auf dem dritten Einschnitt ausgehen wie die ersten Einschnitte, die sich zwischen den Schenkeln der U- oder V-förmigen Abschnitte der dem dritten Einschnitt benachbarten ersten Leiterbahnen erstrecken.

Die Länge der dritten Einschnitte kann wenigstens 50 %, bevorzugt wenigstens 60 %, stärker bevorzugt wenigstens 70 % der Ausdehnung einer zu ihr parallelen Außenkante der Trägerfolie betragen. Sind mehrere zweite Einschnitte vorgesehen, so kann deren Länge gleich oder unterschiedlich sein.

Die ersten, zweiten, dritten und vierten Einschnitte erstrecken sich erfindungsgemäß über die gesamte Stärke der Trägerfolie oder, wenn zusätzlich eine Deckschicht vorgesehen ist, über die gesamte Stärke von Trägerfolie und Deckschicht. Die Einschnitte können zunächst in Form von Perforationen vorgebildet sein, so dass erst bei der Einwirkung von Kraft auf die Perforation der Einschnitt entsteht. Die Breite der Einschnitt kann beliebig gewählt werden. Sie kann beispielsweise 0,1 bis 5 mm, bevorzugt 0,1 bis 2 mm, stärker bevorzugt 0,1 bis 0,5 mm wie 0,2, 0,3 oder 0,4 mm betragen. Einschnitte mit Breiten von 0,1 bis 0,5 mm lassen sich unter anderem mittels Laser herstellen. Die Einschnitte sind vorzugsweise geradlinige Einschnitte, sie können aber auch gekrümmt sein oder gerade und gekrümmte Abschnitte aufweisen. Vorzugsweise haben die Einschnitte über ihre gesamte Länge dieselbe Breite. Die Breite eines Einschnittes kann jedoch auch über seine Länge variieren. Vorzugsweise haben alle Einschnitte die gleiche Breite.

Bei der Trägerfolie handelt es sich um elektrisch isolierendes, flexibles Material. Die Trägerfolie ist vorzugsweise eine Kunststofffolie. Ferner kann eine flexible Deckschicht vorgesehen sein. Dabei kann es sich um eine Folie aus einem elektrischen isolierenden Material, vorzugsweise um eine Kunststofffolie, oder um einen Decklack handeln. Die Kunststofffolien können beispielsweise aus Polyethylen, Polytetrafluorethylen, Polyamid, Polyimid, Polyester, Polyurethan oder einem anderen elektrisch isolierenden Kunststoff bestehen. Die Kunststofffolien können transparent sein. Die Trägerfolie und die Deckschicht können miteinander verklebt sein. Zwischen der Trägerfolie und der Deckschicht sind die Leiterbahnen angeordnet. Die Stärke der Kunststofffolien kann der Stärke der Kunststofffolien entsprechen, die bei Flachbandkabeln (FFC) oder Folienleiterplatten (auch als flexible Leiterplatte (FPC) bezeichnet) üblich sind. Die Flächenseiten der Trägerfolie können rechteckig sein; sie können aber auch andere Formen aufweisen, beispielsweise dreieckig, rombenförmig, trapezförmig, polygonal, kreisförmig, halbkreisförmig oder andere.

Der erfindungsgemäße elektrische Verbinder ermöglicht es, den Abstand zwischen den Endabschnitten der nicht verzweigten Leiterbahnen durch Auseinanderziehen oder Zusammenschieben des elektrischen Verbinders zu verändern. Der elektrische Verbinder kann daher zum elektrischen Verbinden von elektrischen und/oder elektronischen Bauelementen oder deren Anschlüssen mit unterschiedlichen Abständen verwendet werden.

Die Leiterbahnen des erfindungsgemäßen Verbinders können Kupferleiter, Aluminiumleiter oder Leiterbahnen aus einem anderen Material, das den elektrischen Strom leitet, sein. Bevorzugt sind die Leiterbahnen Kupferleiter. Die Leiterbahnen können Runddrähte, Flachleiter, Dünnschichten oder Kombinationen davon, insbesondere Kombinationen aus Runddrähten und Flachleitern sein. Die Höhe der Flachleiter kann beispielsweise 0,2 mm oder weniger, bevorzugt 0,1 mm oder weniger betragen; die Breite des flachen Abschnittes kann beispielsweise 0,5 bis 2 mm betragen. Im Falle einer FPC sind die Leiterbahnen Dünnschichten. Die Leiterbahnen können oberflächenbehandelt sein.

Zum elektrischen Verbinden der elektrischen und/oder elektronischen Bauelemente oder deren Anschlüsse sind an den Endabschnitten der Leiterbahnen zweckmäßigerweise Kontaktelemente ausgebildet. Die Kontaktelemente können jede beliebige Form aufweisen, solange sie den elektrischen Kontakt zwischen dem Bauelement und der Leiterbahn bewirken. Beispielsweise können die Kontaktelemente rund, flach, mit einer oder mehreren Biegungen oder als Lötpins ausgestaltet sein, wobei Kombinationen dieser Merkmale möglich sind.

Ferner können Stützelemente vorgesehen sein. Vorzugsweise sind Stützelemente an den Außenkanten der Trägerfolie angeordnet, an denen sich auch Kontaktelemente befinden. Das ist insbesondere dann vorteilhaft, wenn die Kontaktelemente nicht gleichmäßig über die Außenkante, an der sie sich befinden, verteilt sind. Sie können jedoch alternativ oder zusätzlich auch an Außenkanten der Trägerfolie vorgesehen sein, an denen sich keine Kontaktelemente befinden. Die Stützelemente können aus elektrisch leitenden oder einem isolierenden Material bestehen.

Die Stützelemente können jede beliebige Form aufweisen, sofern sie - insbesondere während des Verlötens des elektrischen Verbinders mit Bauelementen - eine Abstützung des elektrischen Verbinders auf einem Bauelement bewirken können. Beim Verlöten sollten die Stützelemente insbesondere eine horizontale Lage des elektrischen Verbinders gewährleisten. Die Trägerfolie kann so gestaltet sein, dass die Stützelemente in ihr ausgebildet sind. Beispielsweise können in die Trägerfolie Trennungen eingebracht werden, die ein Herausklappen von Segmenten der Trägerfolie, die dann die Stützelemente bilden, ermöglichen.

Die Stützelemente können rund, flach, mit einer oder mehreren Biegungen oder als Lötpins ausgestaltet sein, wobei Kombinationen dieser Merkmale möglich sind. Zweckmäßigerweise haben die Stützelemente dieselbe Form wie die Kontaktelemente. Soll der elektrische Verbinder mit Bauelementen verlötet werden, so sind die Stützelemente zweckmäßigerweise Stützpins. Die Stützelemente können mit einer Leiterbahn, der eine Außenkante der Trägerfolie benachbart ist, elektrisch verbunden sein.

Ferner können Stege vorgesehen sein, die jeweils zwei oder mehr Leiterbahnen elektrisch miteinander verbinden. Die Stege können gemeinsam mit den Leiterbahnen auf der Trägerfolie ausgebildet oder nachträglich auf die Leiterbahnen aufgebracht, beispielsweise aufgeklebt, werden. Mittels der Stege können auf der Trägerfolie elektrische Schaltungen über Kurzschlüsse generiert werden.

Kontaktelemente und Stege können unabhängig voneinander aus demselben Material wie die Leiterbahnen oder aus einem anderen elektrisch leitenden Material bestehen. Dasselbe gilt für die Stützelemente, wenn sie aus einem elektrisch leitenden Material bestehen.

Nach Maßgabe der Erfindung ist ferner ein Verfahren zur Herstellung des erfindungsgemäßen elektrischen Verbinders vorgesehen, das die Schritte umfasst:
(a) Bereitstellen einer Trägerfolie;
(b) Ausbilden der Leiterbahnen auf der Trägerfolie; und
(c) Einbringen der Einschnitte oder von Perforationen dafür in die Trägerfolie.

Die Trägerfolie kann in Schritt (a) als Folienleiterplatte oder als Band bereitgestellt werden. Die Leiterbahnen können in Schritt (b) auf der Trägerfolie durch elektrolytische Abscheidung, Aufwalzen, Stanzen oder Ätzen ausgebildet werden. Im Anschluss an Schritt (b) kann eine Deckschicht auf die Trägerfolie aufgebracht werden. In Schritt (c) werden die Einschnitte oder die Perforationen dafür durch die Deckschicht und die Trägerfolie geführt.

In Schritt (c) können die Einschnitte oder Perforationen mittels Laser, durch Stanzen oder durch Schneiden eingebracht werden. Die Einschnitte oder Perforationen können auch bereits vor dem Ausbilden der Leiterbahnen auf der Trägerfolie in diese eingebracht werden. In diesem Fall wird Schritt (c) vor Schritt (b) ausgeführt. Bei der Herstellung des elektrischen Verbinders müssen in die Deckschicht, insbesondere wenn diese als Decklack ausgebildet ist, nicht zwingend Einschnitte eingebracht werden, die den Einschnitten in der Trägerfolie entsprechen. Bei der Anwendung des elektrischen Verbinders reißt dann der Decklack an den Stellen, die die Einschnitte der Trägerfolie bedecken.

Nach Maßgabe der Erfindung ist darüber hinaus die Verwendung des erfindungsgemäßen elektrischen Verbinders zur elektrischen Verbindung elektrischer und/oder elektronischer Bauelemente oder deren Anschlüssen, insbesondere in einem Kraftfahrzeug, vorgesehen. Dazu kann der erfindungsgemäße elektrische Verbinder auf den Bauelementen, die verbunden werden sollen, montiert werden. Die Montage des elektrischen Verbinders auf den Bauelementen oder deren Anschlüssen kann mittels bekannter Verfahren, beispielsweise durch SMD-Löten, vorgenommen werden. Nach der Montage können die Bauelemente beliebig im Raum, also dreidimensional, angeordnet und montiert werden. Die Abstände zwischen den Bauelementen und die Winkel zwischen dem elektrischen Verbinder und den Bauelementen hängen dabei nur von der Anzahl und Form der Leiterbahnen, der Form der Trägerfolie und der Zahl, Anordnung und Länge der Einschnitte ab. Aufgrund dieser Eigenschaft kann der erfindungsgemäße elektrische Verbinder auch als "3D-Jumper" bezeichnet werden.

Die Erfindung wird nachstehend anhand von Ausführungsbeispielen, die die Erfindung nicht einschränken sollen, unter Bezugnahme auf die Zeichnungen näher erläutert. Dabei zeigen
- Fig. 1: eine erste Ausführungsform des erfindungsgemäßen elektrischen Verbinders (Fig. 1a: Ansicht von vorn; Fig. 1b: Draufsicht; Fig. 1c: perspektivische Darstellung; Fig. 1d: Prinzipdarstellung im gestreckten Zustand);
- Fig. 2: eine zweite Ausführungsform des erfindungsgemäßen elektrischen Verbinders (Fig. 2a: Ansicht von vorn; Fig. 2b: Draufsicht; Fig. 2c: perspektivische Darstellung; Fig. 2d: Prinzipdarstellung im gestreckten Zustand);
- Fig. 3: eine dritte Ausführungsform des erfindungsgemäßen elektrischen Verbinders (Fig. 3a: Ansicht von vorn; Fig. 3b: Draufsicht; Fig. 3c: perspektivische Darstellung; Fig. 3d: Prinzipdarstellung im gestreckten Zustand);
- Fig. 4: eine vierte Ausführungsform des erfindungsgemäßen elektrischen Verbinders (Fig. 4a: Ansicht von vorn; Fig. 4b: Draufsicht; Fig. 4c: perspektivische Darstellung; Fig. 4d: Prinzipdarstellung im gestreckten Zustand); und
- Fig. 5: eine fünfte Ausführungsform des erfindungsgemäßen elektrischen Verbinders (Fig. 5a: Ansicht von vorn; Fig. 5b: Draufsicht).

In den Figuren haben die gleichen Bezugszeichen dieselbe Bedeutung, sofern nichts anderes angegeben ist. Die Figuren mit dem Buchstaben "a" zeigen jeweils eine Draufsicht auf die Außenkante 2a des elektrischen Verbinders 1, wobei in diesen Figuren die Leiterbahnen 3 zwischen einer Trägerfolie 2 und einer Deckschicht, die gemeinsam die Isolationshülle 18 bilden, eingebracht sind. Die Trägerfolie 2 und die Deckschicht sind miteinander verklebt. In den anderen Figuren ist die Deckschicht nicht dargestellt, um die Erkennbarkeit von Leiterbahnen und Einschnitten zu erleichtern. In allen gezeigten Ausführungsformen haben die Trägerfolie, die Deckschicht und die Leiterbahnen jeweils eine Stärke von 0,1 mm, so dass der elektrische Verbinder eine maximale Stärke von 0,3 mm hat.

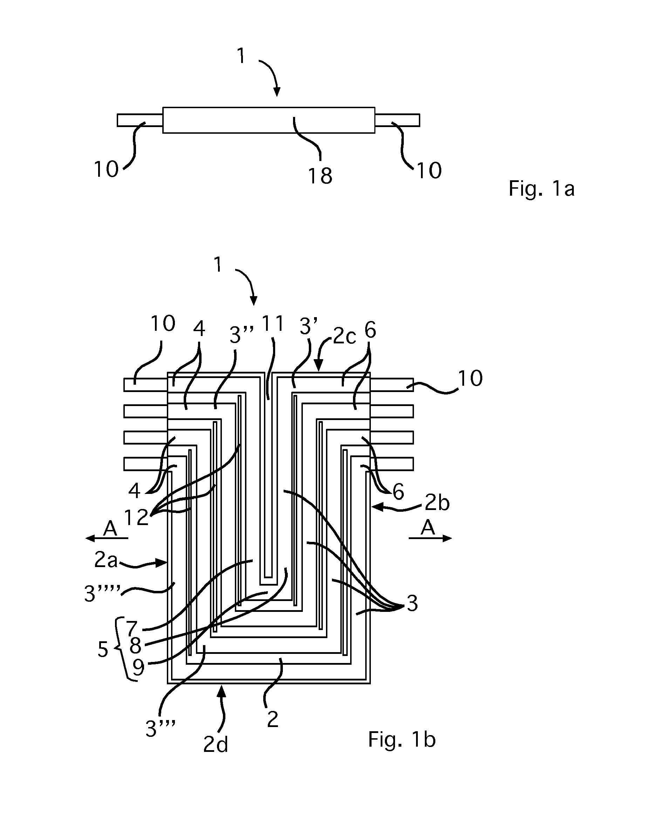

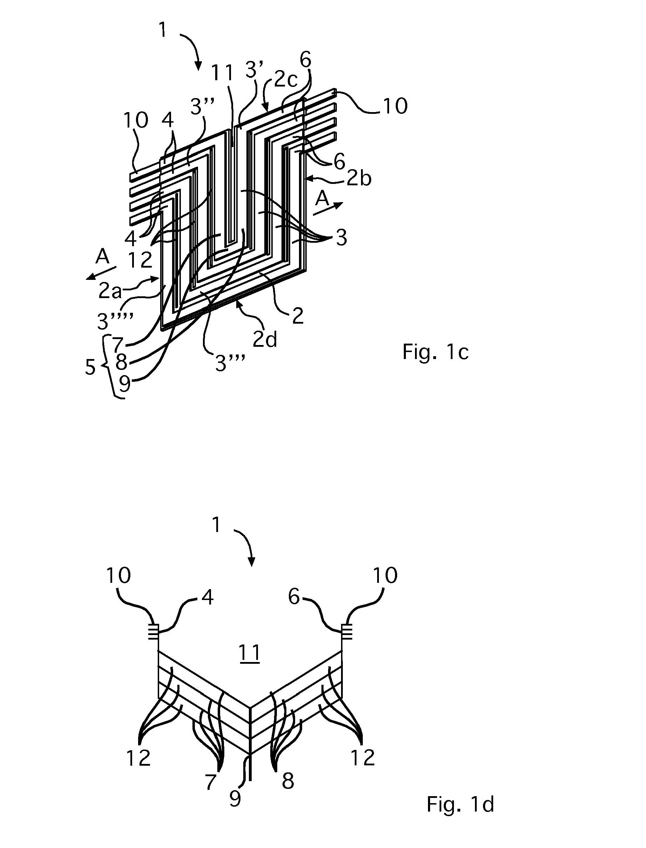

Die in Fig. 1 gezeigte erste Ausführungsform eines erfindungsgemäßen elektrischen Verbinders 1 weist eine Trägerfolie 2 mit rechteckiger Flächenseite auf, auf der flache Leiterbahnen 3 angeordnet sind. Die Leiterbahnen 3 weisen jeweils einen ersten Endabschnitt 4, der an eine Außenkante 2a der Trägerfolie 2 angrenzt, einen U-förmigen Abschnitt 5 und einen zweiten Endabschnitt 6, der an die der Außenkante 2a gegenüberliegende Außenkante 2b der Trägerfolie 2 angrenzt, auf. Der U-förmige Abschnitt 5 ist zwischen dem ersten und dem zweitem Endabschnitt, 4, 6 ausgebildet. Der U-förmige Abschnitt 5 weist einen ersten Schenkel 7 und einen zweiten Schenkel 8 auf, die parallel zueinander verlaufen und über eine Basis 9 miteinander verbunden sind. An den Endabschnitten 4, 6 gehen die elektrischen Leiterbahnen 3 in Kontaktelemente 10 über. Die Kontaktelemente 10 sind flach.

Die U-förmigen Abschnitte sind in Richtung der Außenkante 2c der Trägerfolie 2 geöffnet, die im rechten Winkel zu den Außenkanten 2a, 2b der Trägerfolie 2 verläuft. Zwischen den Schenkeln 7, 8 der Leiterbahn 3' (äußere Leiterband), die der Außenkante 2c benachbart ist, ist ein erster Einschnitt 11 ausgebildet. Der erste Einschnitt 11 erstreckt sich von der Außenkante 2c der Trägerfolie 2 senkrecht zu dieser und parallel zu den Schenkeln 7, 8 in Richtung der Basis 9 des U-förmigen Abschnittes 5 der äußeren Leiterbahn 3', ohne dessen Basis 9 jedoch zu erreichen.

Der U-förmige Abschnitt 5 der zu dieser äußeren Leiterbahn 3' benachbarten, zweiten Leiterbahn 3" umgibt den U-förmigen Abschnitt 5 der äußeren Leiterbahn 3', wobei die Symmetrieachse des U- oder V-förmigen Abschnitts 5 der zweiten Leiterbahn 3" auf der Symmetrieachse des U-förmigen Abschnittes der äußeren Leiterbahn 3' liegt. Zwischen der äußeren Leiterbahn 3' und der zweiten Leiterbahn 3" sind zweite Einschnitte 12 vorgesehen, die sich zwischen benachbarten Schenkeln 8 bzw. benachbarten Schenkeln 9 der U-förmigen Abschnitte 5 der äußeren Leiterbahn 3' und der zweiten Leiterbahn 3" befinden. Die zweiten Einschnitte 12 verlaufen mittig zwischen den Schenkeln 8, 9. Eine dritte, der zweiten Leiterbahn 3" benachbarte Leiterbahn 3"' umgibt mit ihrem U-förmige Abschnitt 5 den U- oder V-förmigen Abschnitt 5 der zweiten Leiterbahn 3", wobei die Symmetrieachse des U-förmigen Abschnitts 5 der dritten Leiterbahn 3"' auf der Symmetrieachse des U-förmigen Abschnittes 5 der zweiten Leiterbahn 3" liegt. Auch zwischen der zweiten Leiterbahn 3" und der dritten Leiterbahn 3"' sind zweite Einschnitte 12 vorgesehen, die sich zwischen den benachbarten Schenkeln 8 bzw. benachbarten Schenkeln 9 der U- oder V-förmigen Abschnitte 5 der zweiten Leiterbahn 3" und der dritten Leiterbahn 3'" befinden. Das für die dritte Leiterbahn gesagte gilt jeweils auch für die vierte Leiterbahn 3"" mit dem Unterschied, dass an die Stelle der zweiten Leiterbahn 3" die dritte Leiterbahn 3'" tritt.

Vierte Einschnitte sind nicht vorgesehen, dies wäre aber möglich.

Wird der elektrische Verbinder 1 in Richtung der in Fig. 1b gezeigten Pfeile A auseinander gezogen, so gelangt der elektrische Verbinder 1 in die in Fig. 1e schematisch gezeigte Form.

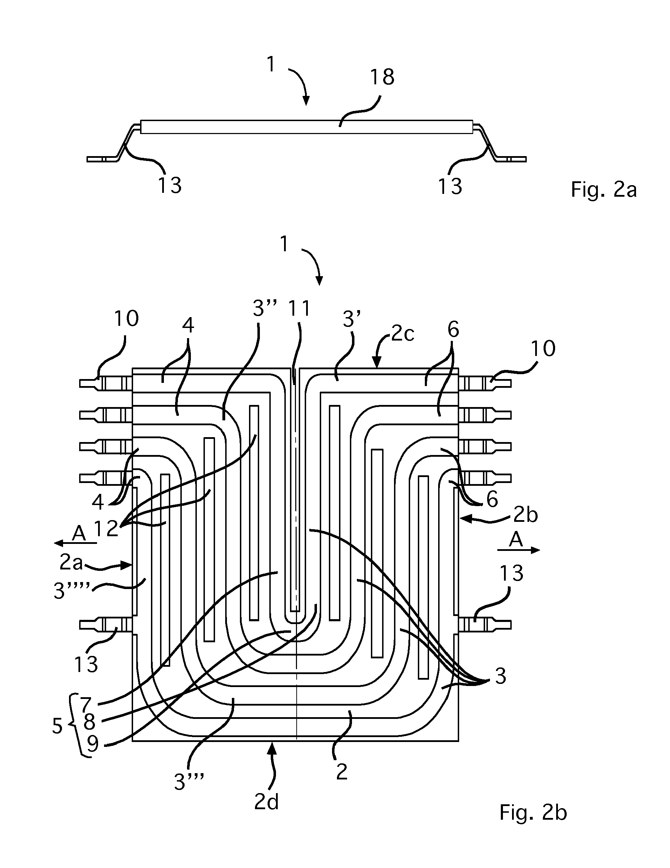

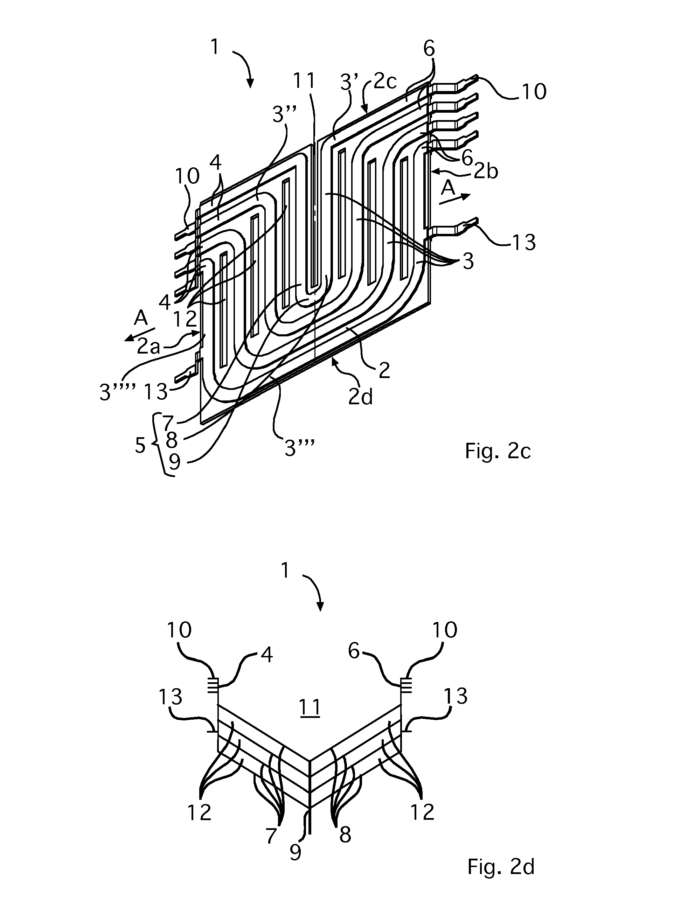

Die in Fig. 2 gezeigte Ausführungsform entspricht der in Fig. 1 gezeigten Ausführungsform, außer dass die Kontaktelemente 10 zweifach gebogen sind und dass ferner Stützelemente 13 vorgesehen sind, deren Form der Form der Kontaktelemente 10 entspricht. Jeweils ein Stützelement 13 ist an den Außenkanten 2a, 2b der Trägerfolie 2 vorgesehen, an der sich auch Kontaktelemente 10 befinden. Die Stützelemente sind mit der vierten Leiterbahn 3"" elektrisch leitend verbunden.

Vierte Einschnitte sind nicht vorgesehen, dies wäre aber möglich.

Wird der elektrische Verbinder 1 in Richtung der in Fig. 2b gezeigten Pfeile A auseinander gezogen, so gelangt der elektrische Verbinder 1 in die in Fig. 2e schematisch gezeigte Form.

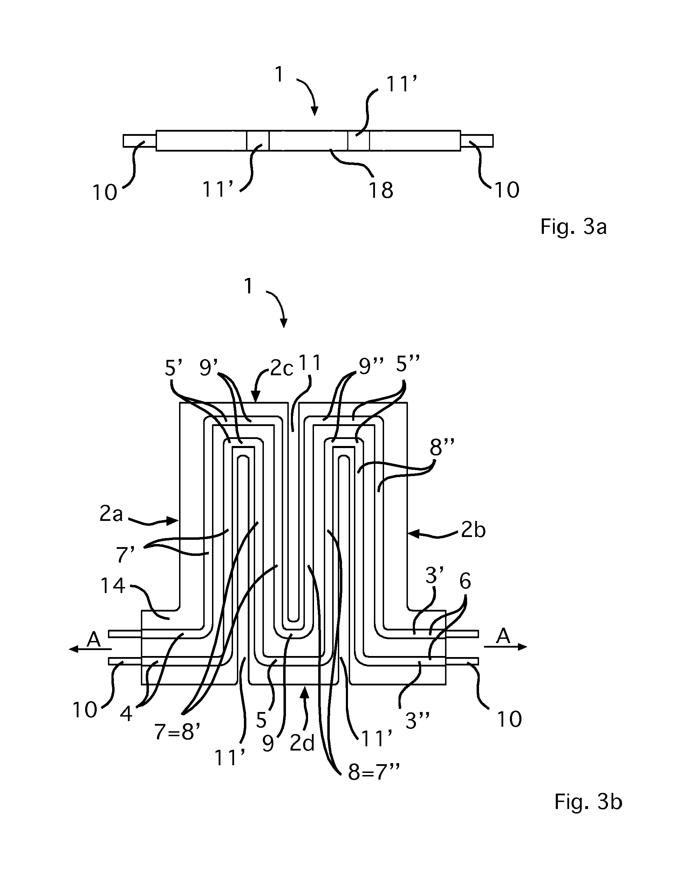

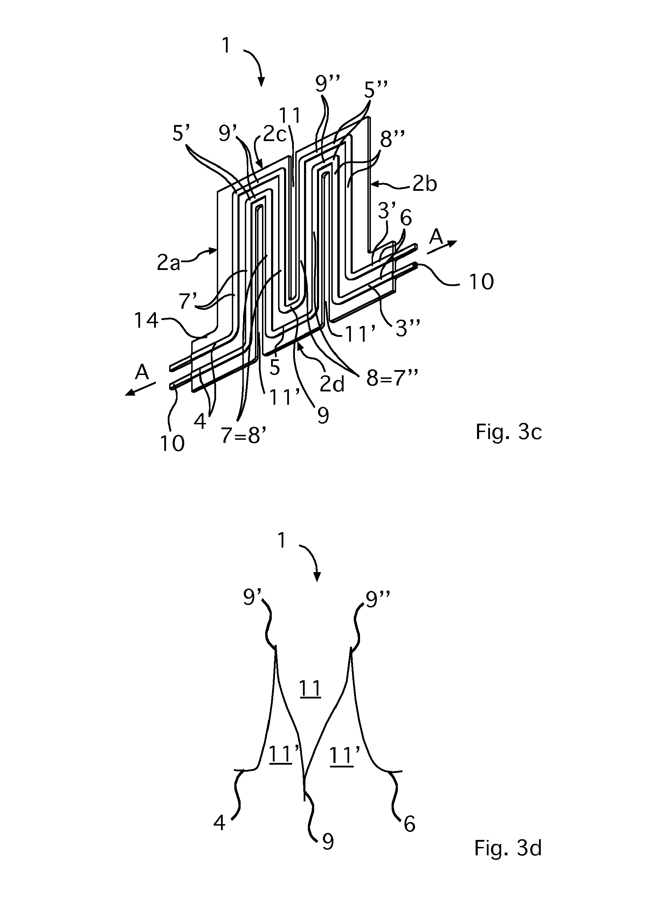

Die in Fig. 3 gezeigte dritte Ausführungsform eines erfindungsgemäßen elektrischen Verbinders 1 weist eine Trägerfolie 2 auf, deren Flächenseite parallele Außenkanten aufweist, wobei in die gegenüberliegenden und parallelen Außenkanten 2c, 2d erste Einschnitte 11, 11' eingebracht sind. Die Endabschnitte 4, 6 der Leiterbahnen 3, die auf der Flächenseite der Trägerfolie 2 angeordnet sind, befinden sich auf rechteckigen Segmenten 14 der Trägerfolie 2, die über die gegenüberliegenden und parallelen Außenkanten 2a, 2b hinaustreten, wobei sie an die Außenkante 2d angrenzen. Die Außenkanten 2a, 2b verlaufen orthogonal zu den Außenkanten 2c, 2d. An den Endabschnitten 4, 6 gehen die elektrischen Leiterbahnen 3 in Kontaktelemente 10 über. Die Kontaktelemente 10 sind flach.

Die Leiterbahnen 3 weisen jeweils drei U-förmige Abschnitte 5, 5', 5" auf, die zwischen dem ersten und dem zweitem Endabschnitt, 4, 6 ausgebildet. Die U-förmigen Abschnitte sind alternierend in Richtung der Außenkanten 2a, 2b geöffnet. Dabei ist der erste U-förmige Abschnitt 5 zwischen den U-förmigen Abschnitten 5', 5" angeordnet. Der U-förmige Abschnitt 5 weist einen ersten Schenkel 7 und einen zweiten Schenkel 8 auf, die parallel zueinander verlaufen und über eine Basis 9 miteinander verbunden sind. Der zweite U-förmigen Abschnitt 5' weist einen ersten Schenkel 7' und einen zweiten Schenkel 8' auf, die parallel zueinander verlaufen und über eine Basis 9' miteinander verbunden sind. Der erste Schenkel 7 des ersten U-förmigen Abschnittes 5 bildet den zweiten Schenkel 8' des zweiten zweite U-förmigen Abschnittes 5'. Der dritte U-förmigen Abschnitt 5" weist einen ersten Schenkel 7" und einen zweiten Schenkel 8" auf, die parallel zueinander verlaufen und über eine Basis 9" miteinander verbunden sind. Der erste Schenkel 8 des ersten U-förmigen Abschnittes 5 bildet den zweiten Schenkel 7" des dritten U-förmigen Abschnittes 5".

Die U-förmigen Abschnitte 5 beider Leiterbahnen 3', 3" sind in Richtung der Außenkante 2c der Trägerfolie 2 geöffnet. Zwischen den Schenkeln 7, 8 der Leiterbahn 3', die der Außenkante 2c benachbart ist, ist ein erster Einschnitt 11 ausgebildet. Der erste Einschnitt 11 erstreckt sich von der Außenkante 2c der Trägerfolie 2 senkrecht zu dieser und parallel zu den Schenkeln 7, 8 in Richtung der Basis 9 des U-förmigen Abschnittes 5 der ersten Leiterbahn 3', ohne die Basis 9 jedoch zu erreichen. Der U-förmige Abschnitt 5 der zu dieser ersten Leiterbahn 3' benachbarten, zweiten Leiterbahn 3" umgibt den U-förmigen Abschnitt 5 der ersten Leiterbahn 3', wobei die Symmetrieachse des U-förmigen Abschnitts 5 der zweiten Leiterbahn 3" auf der Symmetrieachse des U-förmigen Abschnittes 5 der ersten Leiterbahn 3' liegt.

Die U-förmigen Abschnitte 5', 5" beider Leiterbahnen 3', 3" sind in Richtung der Außenkante 2d der Trägerfolie 2 geöffnet. Zwischen den Schenkeln 7', 8' und zwischen den Schenkeln 7", 8" der zweiten Leiterbahn 3", die der Außenkante 2d benachbart ist, sind erste Einschnitte 11' ausgebildet. Ein erster Einschnitt 11' erstreckt sich von der Außenkante 2d der Trägerfolie 2 senkrecht zu dieser und parallel zu den Schenkeln 7', 8' in Richtung der Basis 9' des U-förmigen Abschnittes 5' der Leiterbahn 3", ohne die Basis 9' jedoch zu erreichen. Der U-förmige Abschnitt 5' der zu dieser zweiten Leiterbahn 3" benachbarten, ersten Leiterbahn 3' umgibt den U-förmigen Abschnitt 5' der zweiten Leiterbahn 3", wobei die Symmetrieachse des U-förmigen Abschnitts 5' der ersten Leiterbahn 3' auf der Symmetrieachse des U-förmigen Abschnittes 5' der zweiten Leiterbahn 3" liegt.

Ein zweiter Einschnitt 11' erstreckt sich von der Außenkante 2d der Trägerfolie 2 senkrecht zu dieser und parallel zu den Schenkeln 7", 8" in Richtung der Basis 9" des U-förmigen Abschnittes 5" der Leiterbahn 3", ohne die Basis 9" jedoch zu erreichen. Der U-förmige Abschnitt 5" der zu dieser zweiten Leiterbahn 3" benachbarten, ersten Leiterbahn 3' umgibt den U-förmigen Abschnitt 5" der zweiten Leiterbahn 3", wobei die Symmetrieachse des U-förmigen Abschnitts 5" der ersten Leiterbahn 3' auf der Symmetrieachse des U-förmigen Abschnittes 5" der zweiten Leiterbahn 3" liegt.

Zwischen der ersten Leiterbahn 3' und der zweiten Leiterbahn 3" sind keine zweite Einschnitte 12 und keine vierten Einschnitte 19 vorgesehen. Es könnten aber zweite und/oder vierte Einschnitte vorgesehen sein.

Wird der elektrische Verbinder 1 in Richtung der in Fig. 3b gezeigten Pfeile A auseinander gezogen, so gelangt der elektrische Verbinder 1 in die in Fig. 3e schematisch gezeigte Form.

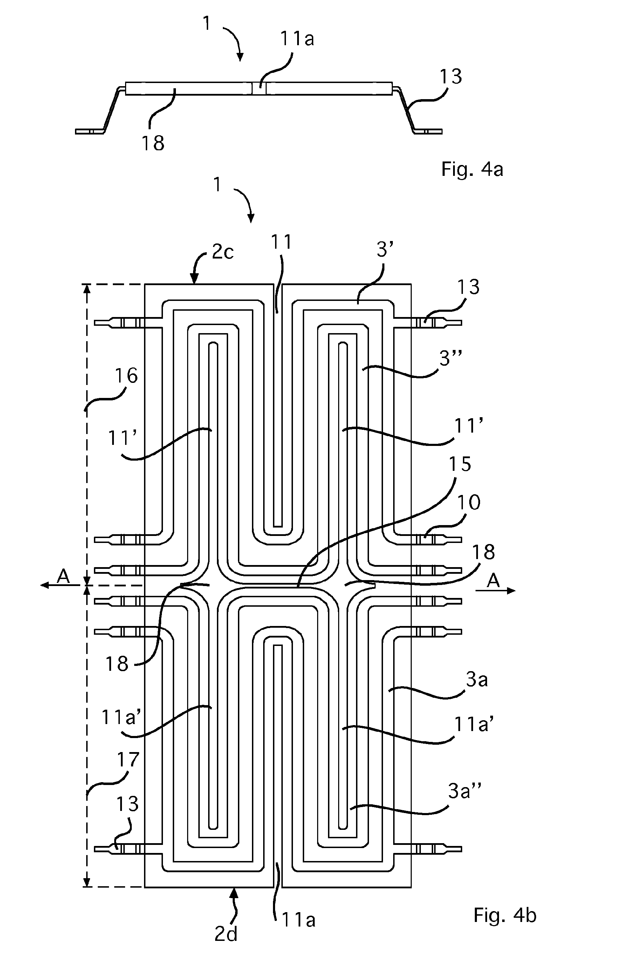

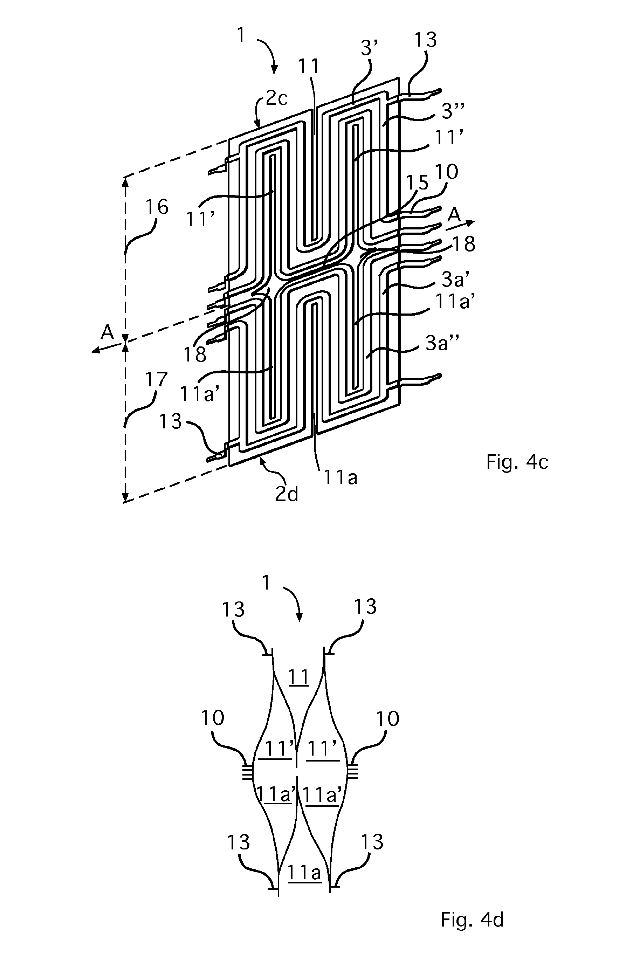

Die in Fig. 4 gezeigte Ausführungsform eines erfindungsgemäßen elektrischen Verbinders weist erste Einschnitte 11, 11', 11a, 11a' sowie einen dritten Einschnitt 15 auf. Der dritte Einschnitt 15 teilt die rechteckige Flächenseite der Trägerfolie 2 in einen ersten Sektor 16 und einen zweiten Sektor 17. Der dritte Einschnitt 15 verläuft dabei parallel zu den Außenkanten 2c, 2d der Trägerfolie 2. Von dem dritten Einschnitt 15 erstrecken sich dazu senkrechte erste Einschnitte 11' in den ersten Sektor 16 und erste Einschnitte 11a' in den zweiten Sektor 17.

Der erste Einschnitt tritt dabei an die Stelle einer Außenkante im Vergleich zu der in Fig. 3 gezeigten Ausführungsform. Abgesehen davon (und dass keine Segmente 14 vorgesehen sind) entspricht die Lage der Leiterbahnen 3', 3" im ersten Sektor 16 der in Fig. 3 gezeigten Ausführungsform. Die Leiterbahnen 3a', 3a" des zweiten Sektors 17 sind spiegelsymmetrisch zu den Leiterbahnen 3', 3" des ersten Sektors 17 angeordnet. Ein weiterer erster Einschnitt 11a, der dem Einschnitt 11 des ersten Sektors 16 entspricht, erstreckt sich dabei von der Außenkante 2d in Richtung des dritten Einschnittes 15.

Vierte Einschnitte sind nicht ausgebildet. Allerdings könnten zweite Einschnitte und/oder vierte Einschnitte zwischen benachbarten Leiterbahnen eines Sektors 16, 17 vorgesehen sein.

An den Schnittpunkten zwischen dem dritten Einschnitt 15 und den ersten Einschnitten 11', 11a', die von dem dritten Einschnitt 15 ausgehen, sind gegenüber den Einschnitten verbreitete Öffnungen 18 in der Trägerfolie 2 ausgebildet. Diese Öffnungen 18, die sich über die gesamte Stärke der Trägerfolie 2 erstrecken, erleichtern das Auseinanderziehen des elektrischen Verbinders 1 weiter.

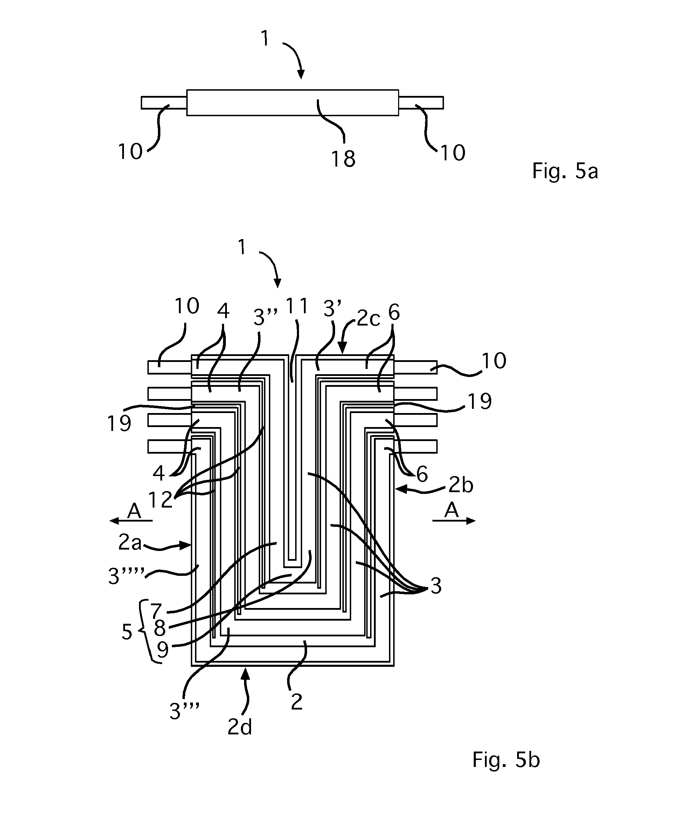

Die in Fig. 5 gezeigte Ausführungsform des elektrischen Verbinders entspricht der in Fig. 1 gezeigten Ausführungsform, außer dass zusätzlich vierte Einschnitte 19 vorgesehen sind, die sich zwischen benachbarten Endabschnitten 4, 6 der Leiterbahnen 3 von der Außenkante 2a bis zu den zweiten Einschnitten 12 oder von der Außenkante 2b bis zu den zweiten Einschnitten 12 erstrecken.

### Bezugszeichenliste

- 1: Elektrischer Verbinder
- 2: Trägerfolie
- 3: Leiterbahn
- 3a: spiegelsymmetrische Leiterbahn
- 4: erster Endabschnitt
- 5: U-förmiger Abschnitt
- 6: zweiter Endabschnitt
- 7: erster Schenkel
- 8: zweiter Schenkel
- 9: Basis
- 10: Kontaktelement
- 11: erster Einschnitt
- 12: zweiter Einschnitt
- 13: Stützelement
- 14: Segment
- 15: dritter Einschnitt
- 16: erster Sektor
- 17: zweiter Sektor
- 18: Isolationshülle
- 19: vierter Einschnitt

## Patentansprüche

1. Elektrischer Verbinder mit einer Trägerfolie (2), auf der zumindest eine nicht verzweigte elektrische Leiterbahn (3) angeordnet ist, **dadurch gekennzeichnet, dass** die Leiterbahn (3) zwischen ihren Endabschnitten (4, 6) zumindest einen U- oder V-förmigen Abschnitt (5) aufweist, wobei zwischen den sich gegenüberliegenden Schenkeln (7, 8) des Abschnittes (5) ein erster Einschnitt (11) in die Trägerfolie (2) eingebracht ist.

2. Elektrischer Verbinder nach Anspruch 1, **dadurch gekennzeichnet, dass** der erste Einschnitt (11) an einer Außenkante (2c) der Trägerfolie (2) beginnt.

3. Elektrischer Verbinder nach Anspruch 1 oder Anspruch 2, **dadurch gekennzeichnet, dass** zumindest ein zweiter Einschnitt (12) vorgesehen ist, der zwischen benachbarten Leiterbahnen (3', 3 ") ausgebildet ist, wobei der zweite Einschnitt (12) von den Außenkanten der Trägerfolie (2) beabstandet ist.

4. Elektrischer Verbinder nach Anspruch 3, **dadurch gekennzeichnet, dass** der zweite Einschnitt (12) parallel zu dem ersten Einschnitt (11) verläuft.

5. Elektrischer Verbinder nach einem der vorstehenden Ansprüche, **dadurch gekennzeichnet, dass** die Endabschnitte (4, 6) der Leiterbahnen an gegenüberliegenden Außenkanten (2a, 2b) der Trägerfolie (2) angeordnet sind und dass der zumindest eine erste Einschnitt (11) an einer anderen Außenkante (2c) der Trägerfolie (2) beginnt.

6. Elektrischer Verbinder nach einem der vorstehenden Ansprüche, **dadurch gekennzeichnet, dass** die Leiterbahnen (3) mehrere U- oder V-förmige Abschnitte (5, 5', 5 ") aufweisen, wobei die U- oder V-förmigen Abschnitte (5, 5', 5 ") der Leiterbahnen (3) alternierend zu einer Außenkante (2c) oder zu der dazu gegenüberliegenden Außenkante (2d) der Trägerfolie (2) geöffnet sind.

7. Elektrischer Verbinder nach einem der vorstehenden Ansprüche, **dadurch gekennzeichnet, dass** zumindest eine erste nicht verzweigte Leiterbahn (3) und zumindest eine zweite nicht verzweigte Leiterbahn (3a) vorgesehen sind, wobei sowohl die erste als auch die zweite Leiterbahn (3, 3a) zwischen ihren jeweiligen U- oder V-förmigen Abschnitten (5, 5a) jeweils einen ersten Einschnitt (11, 11a) aufweisen und wobei die zweite Leiterbahn (3a) spiegelsymmetrisch zu der ersten Leiterbahn (3) auf der Trägerfolie (2) angeordnet ist.

8. Elektrischer Verbinder nach Anspruch 7, **dadurch gekennzeichnet, dass** zwischen der zumindest einen ersten Leiterbahn (3) und der zumindest einen zweiten Leiterbahn (3a) ein dritter Einschnitt (15) ausgebildet ist, der von den Außenkanten der Trägerfolie (2) beabstandet und quer zu den ersten Einschnitten (11, 11', 11a, 11a') verläuft.

9. Elektrischer Verbinder nach einem der vorstehenden Ansprüche, **dadurch gekennzeichnet, dass** der Abstand zwischen den Endabschnitten (4. 6) der nicht verzweigten Leiterbahnen (3, 3a) durch Auseinanderziehen oder Zusammenschieben des elektrischer Verbinders variierbar ist.

10. Elektrischer Verbinder nach einem der vorstehenden Ansprüche, **dadurch gekennzeichnet, dass** an den Endabschnitten (4, 6) der Leiterbahnen Kontaktelemente (10) ausgebildet sind.

11. Elektrischer Verbinder nach einem der vorstehenden Ansprüche, **dadurch gekennzeichnet, dass** ferner Stützelemente (13) vorgesehen sind, die mit einer Leiterbahn (3, 3a), die einer Außenkante der Trägerfolie (2) benachbart ist, elektrisch verbunden sind.

12. Elektrischer Verbinder nach Anspruch 11, **dadurch gekennzeichnet, dass** die Kontaktelemente (10) von den Stützelementen (13) beabstandet an den Außenkanten der Trägerfolie (2) angeordnet sind, an denen sich Kontaktelemente (10) befinden.

13. Elektrischer Verbinder nach einem der vorstehenden Ansprüche, **dadurch gekennzeichnet, dass** zumindest ein Steg vorgesehen ist, der zwei Leiterbahnen (3, 3a) elektrisch miteinander verbindet.

14. Verfahren zur Herstellung eines elektrischen Verbinders nach einem der Ansprüche 1 bis 13, **dadurch gekennzeichnet, dass** es die Schritte
(a) Bereitstellen einer Trägerfolie (2);
(b) Ausbilden der Leiterbahnen (3, 3a) auf die Trägerfolie (2); und
(c) Einbringen der Einschnitte (11, 12, 15) in die Trägerfolie (2) umfasst.

15. Verwendung eines elektrischen Verbinders nach einem der Ansprüche 1 bis 13, zur elektrischen Verbindung elektronischer Bauelemente oder deren Anschlüssen in einem Kraftfahrzeug.
